# EUROPÄISCHE PATENTSCHRIFT

(11) **EP 1 558 422 B1**
(45) Veröffentlichungstag und Bekanntmachung des Hinweises auf die Patenterteilung: **22.11.2006**
(21) Anmeldenummer: 03779671.1
(22) Anmeldetag: 27.10.2003
(51) Int. Cl.: B23K 26/38, H05K 3/00

(54) **VERFAHREN ZUM BOHREN VON LÖCHERN MITTELS EINES LASERSTRAHLS IN EINEM SUBSTRAT, INSBESONDERE IN EINEM ELEKTRISCHEN SCHALTUNGSSUBSTRAT**
METHOD FOR BORING HOLES IN A SUBSTRATE, ESPECIALLY IN AN ELECTRICAL CIRCUIT SUBSTRATE, BY MEANS OF A LASER BEAM
PROCEDE DE PERCAGE DE TROUS DANS UN SUBSTRAT A L'AIDE D'UN RAYON LASER, NOTAMMENT DANS UN SUBSTRAT DE CIRCUIT

(30) Priorität: 05.11.2002 DE 10251480
(43) Veröffentlichungstag der Anmeldung: 03.08.2005
(73) Patentinhaber: Hitachi Via Mechanics, Ltd., Ebina-Shi Kanagawa 243-0488 (JP)
(72) Erfinder: KILTHAU, Alexander, 76669 Bad Schönborn (DE); MAYER, Hans, Jürgen, 68519 Viernheim (DE); VAN BIESEN, Marc, B-9280 Wieze (BE)
(74) Vertreter: Beetz & Partner
(86) Internationale Anmeldenummer: PCT/DE2003/003564
(87) Internationale Veröffentlichungsnummer: WO 2004/041474

(56) Entgegenhaltungen:
- EP-A- 0 795 375
- US-A- 3 742 182
- US-A- 5 632 913
- US-A1- 2001 045 419
- "TREPANNING MOVES IN ON MINI HOLES" MACHINERY AND PRODUCTION ENGINEERING, MACHINERY PUBLISHING CO.LTD. BURGESS HILL, GB, November 1983 (1983-11), Seiten 42-43, XP001109471 ISSN: 0024-919X

## Beschreibung

Die Erfindung betrifft ein Verfahren zum Bohren von Löchern mittels eines Laserstrahls in einem Substrat, insbesondere in einem elektrischen Schaltungssubstrat, wobei der Laserstrahl mit einem Strahl-Fleckdurchmesser, der kleiner ist als der zu bohrende Lochdurchmesser, jeweils im Bereich eines zu bohrenden Loches auf mindestens einer Kreisbahn bewegt wird.

Aus der US 5 593 606 ist ein derartiges Verfahren bekannt, wobei Löcher mit einem größeren Durchmesser als der Strahldurchmesser des Lasers dadurch erzeugt werden, daß der Laserstrahl entweder in Spiralbahnen oder in konzentrischen Kreisen innerhalb des Lochbereiches von innen nach außen oder von außen nach innen bewegt wird.

Beim Bohren von Leiterplatten oder vergleichbaren Schaltungssubstraten werden nach einer Optimierung die Positionen der Bohrlöcher nacheinander mit der jeweils verwendeten Ablenkeinheit angefahren. Dabei sind zweckmäßigerweise die Form und das Bearbeiten bzw. das Abarbeiten des Bohrloches durch ein Programm (ein sog. Bohrtool) vordefiniert. Mit diesem Programm wird jedes Loch in der gleichen Art und Weise abgearbeitet. In einer zweckmäßigen Vorgehensweise, für ein besonders genaues und schnelles Bohrverfahren ist dabei festgelegt, daß der Laserstrahl von einer Ausgangsposition, beispielsweise einem vorhergehenden Bohrloch, auf die Mitte des neu zu bohrenden Loches springt und von dort in einer immer gleichen, definierten Winkelrichtung in die erste Kreisbahn verfahren wird. Nach Durchlaufen dieser ersten Kreisbahn kann der Strahl dann, falls nötig, in weitere Kreisbahnen verfahren werden. Wenn nun die Verfahrrichtung aus dem Mittelpunkt zu der ersten Kreisbahn in einem vorgegebenen Winkel festgelegt ist, während die vorangehende Sprungrichtung von jeweils unterschiedlichen Ausgangspunkten (Bohrlöchern) ganz unterschiedliche Winkel einnimmt, bedeutet dies für die Mehrheit aller Löcher, daß zwischen dem Sprung zum Lochmittelpunkt und der Verfahrbewegung zur Kreisbahn eine Richtungsänderung erforderlich ist, die bis zu 180° betragen kann. Je größer diese Richtungsänderung zwischen der Sprungrichtung und der Verfahrrichtung ist, um so größer ist auch die notwendige abrupte Stellungsänderung der Ablenkeinheit, d.h. in der Regel, der Galvospiegel. Ein winkelige Richtungsänderung bedeutet dabei immer einen Zeitverlust durch die notwendige Beruhigungszeit der Spiegel nach der Bewegung sowie einen Streßfaktor für die Galvomotoren, weil höhere Spitzenströme fließen; das wirkt sich negativ auf deren Lebensdauer aus. Wenn auf eine Beruhigungszeit der Spiegel verzichtet wird, verschlechtert sich die Lochqualität, d.h. man erhält unrunde Löcher. Insbesondere bei einer Richtungsumkehr von etwa 180° ist darüber hinaus zunächst ein Stillstand notwendig, auf den ein erneutes Beschleunigen folgt, wobei ein neuer Schleppfehler der Galvomotoren auftritt.

Ziel der vorliegenden Erfindung ist es, das oben genannte Verfahren zum Bohren von Löchern in Substraten derart zu verbessern, daß eine höhere Prozeßgeschwindigkeit bei gleichzeitig guter Lochqualität, d.h. guter Rundheit der Löcher, erreicht wird. Zugleich sollen die Ablenkeinheiten weniger beansprucht werden, d.h., daß insbesondere Galvomotoren eine höhere Lebensdauer erreichen.

Erfindungsgemäß wird dieses Ziel dadurch erreicht, daß jeweils bei der Ausrichtung des Laserstrahls auf ein neues Bohrloch die Strahlachse zunächst in einer durch die Strahlposition vorgegebenen Sprungrichtung in den Mittelpunkt des zu bohrenden Loches und dann in einer definierten radialen Verfahrbewegung aus dem Mittelpunkt heraus auf eine definierte Kreisbahn gelenkt wird und
daß die Winkelrichtung der Verfahrbewegung in Abhängigkeit von der Sprungrichtung derart definiert wird, daß eine Richtungsänderung der Strahlachse im Mittelpunkt einen vorgegebenen maximalen Winkelbereich nicht übersteigt oder daß - idealerweise - die Richtung beibehalten wird.

Bei dem erfindungsgemäßen Verfahren wird also in Abhängigkeit von der Sprungrichtung von dem jeweils letzten Loch die Bewegung aus der Lochmitte heraus so gewählt, daß abrupte Richtungsänderungen, beispielsweise von mehr als 225°, vermieden werden.

Dies kann in einer ersten Ausgestaltung des erfindungsgemäßen Verfahrens dadurch geschehen, daß das vorgegebene Bohrprogramm für ein Loch in jedem Einzelfall dahingehend variiert wird, daß die Winkelrichtung der Verfahrbewegung an die Sprungrichtung des ankommenden Laserstrahls angepaßt wird. In diesem Fall gibt es dann im Lochmittelpunkt keine oder so gut wie keine Richtungsänderung, doch ist eine solche Lösung sehr aufwendig.

Für die meisten Anwendungsfälle ist deshalb eine Ausgestaltung des erfindungsgemäßen Verfahrens günstig, bei der entsprechend dem vorgegebenen maximalen Winkelbereich eine Anzahl von Winkelrichtungen für die Verfahr-Bewegung vorgegeben ist, denen jeweils ein Winkelbereich für ankommende Sprungrichtungen zugeordnet ist, wobei je nach dem, in welchem Winkelbereich die Sprungrichtung liegt, ein zugehöriges Bohrprogramm mit der zugehörigen Verfahr-Richtung auswählbar ist. Beträgt beispielsweise der maximal zulässige Winkelbereich für eine Richtungsänderung im Mittelpunkt 45°, so werden für die ankommenden Sprungrichtungen acht Winkelbereiche von jeweils 45° festgelegt, denen jeweils eine abgehende Verfahrrichtung mit einem zugehörigen Bohrprogramm zugeordnet wird. Je nach dem, unter welcher Sprungrichtung der Laserstrahl ankommt, wird dann das zugehörige Bohrprogramm ausgewählt und umgesetzt.

Die Erfindung wird nachfolgend an Ausführungsbeispielen anhand der Zeichnung näher erläutert. Es zeigt
Figur 1 eine schematisch dargestellte Laseranordnung zum Bohren von Löchern in einem Mehrschichtsubstrat,
Figur 2 den Weg der Strahlachse eines ankommenden Laserstrahls im Bereich eines zu bohrenden Loches ohne Winkeländerung im Mittelpunkt,
Figur 3 den Weg eines ankommenden Laserstrahls im Bereich eines zu bohrenden Loches bei maximaler Winkeländerung im Mittelpunkt,
Figuren 4 bis 11 den Weg der Achse eines Laserstrahls im Bereich eines zu bohrenden Loches nach dem erfindungsgemäßen Verfahren bei unterschiedlichen Sprungrichtungen des ankommenden Strahles.

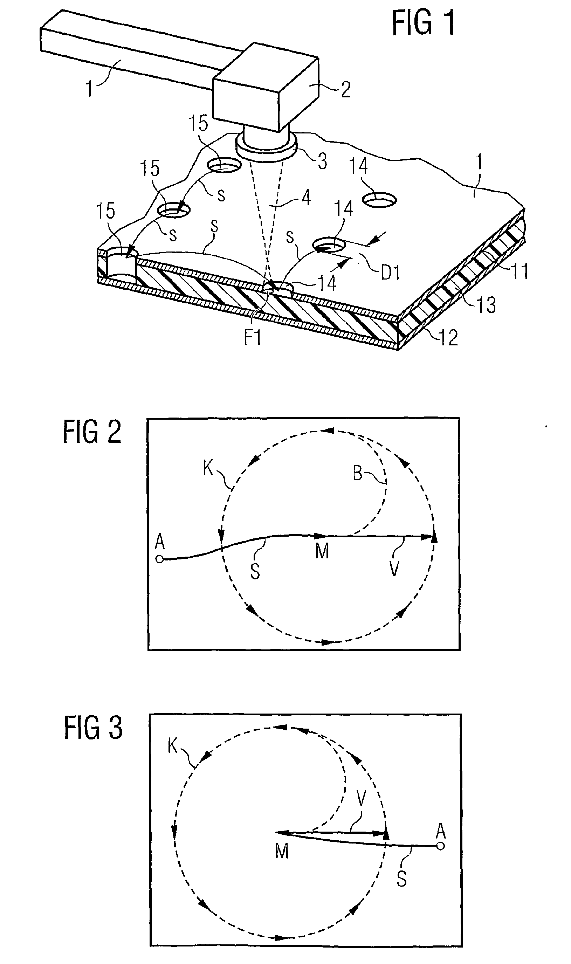

Die in Figur 1 schematisch und keineswegs maßstabsgerecht gezeigte Anordnung zeigt einen Laser 1 mit einer Ablenkeinheit 2 und einer optischen Abbildungseinheit 3, über die ein Laserstrahl 4 auf ein Substrat 10, vorzugsweise eine Leiterplatte, gerichtet wird. Dieses Substrat 10 besitzt in dem gezeigten Beispiel eine obere, erste Metallschicht (beispielsweise eine Kupferschicht) 11 sowie eine untere, zweite Metallschicht 12, zwischen denen eine Dielektrikumsschicht 13 angeordnet ist. Diese Dielektrikumsschicht besteht beispielsweise aus einem Polymermaterial, wie RCC oder einem glasfaserverstärkten Polymermaterial, wie FR4. Es ist bekannt, daß die Metallschichten, die in der Regel aus Kupfer bestehen, eine andere Energiemenge zur Bearbeitung bzw. Übertragung erfordern als das Dielektrikum. Entsprechend können auch unterschiedliche Lasereinstellungen, wie unterschiedliche Pulswiederholraten und unterschiedliche Fokussierungen des Laserstrahls gewählt werden.

Wie in Figur 1 gezeigt ist, sollen in das Substrat 1 jeweils Sack- oder Durchgangslöcher 15 mit einem Durchmesser D1 gebohrt werden. Zu diesem Zweck können beispielsweise mit einer ersten Einstellung des Lasers Löcher 14 durch die Kupferschicht 11 gebohrt werden, und dann können mit einer anderen Lasereinstellung die Sacklöcher 15 in die Dielektrikumsschicht 13 eingebracht werden. Unabhängig davon, welches Material gebohrt wird, wird hier davon ausgegangen, daß der Laserstrahl 4 jeweils mit seinem Brennfleck F1 in konzentrischen Kreisen in dem zu bohrenden Lochbereich bewegt wird, bis das Material vollständig aus dem betreffenden Loch 14 bzw. 15 entfernt ist. Die einzelnen Löcher werden nacheinander bearbeitet, so daß jeweils der Laserstrahl bzw. die optische Achse des während des Sprungs abgeschalteten oder mit sehr geringer Energie (bei 355 nm UV z.B. im CW-Modus) betriebenen Laserstrahls von einem Lochbereich zum nächsten springt.

In Figur 1 ist diese Sprungrichtung von einem Loch zum anderen jeweils mit einem Pfeil S angedeutet. Der Sprung verläuft also jeweils von einem Ausgangspunkt an einem vorangehenden Loch, beispielsweise nach Vollendung des Bohrvorgangs an einem Randpunkt oder Lochmittelpunkt, in annähernd gerader Linie zum Mittelpunkt des nachfolgend zu bohrenden Loches. Von diesem Mittelpunkt M aus wird dann ein fest vorgegebenes Bohrprogramm gestartet, wobei die Achse des Laserstrahls zunächst in einer fest vorgegebenen Verfahrrichtung V oder alternativ bereits vom Kreismittelpunkt aus auf eine Kreisbahn gebracht wird. Beim Erreichen der Kreisbahn wird der Laser eingeschaltet, und der Laserstrahl durchläuft die Kreisbahn in einem oder mehreren Umläufen, je nach den gegebenen Voraussetzungen, wie Substratmaterial, Bohrlochtiefe, Art und Energiedichte des Lasers usw. Erfordert die Größe des Bohrlochs mehrere konzentrische Umläufe des Lasers, so wird der Laserstrahl nach ein- oder mehrmaligem Durchlaufen der ersten Kreisbahn auf eine weitere Kreisbahn verfahren. In der Praxis wird der Laserstrahl bzw. die Strahlachse des abgeschalteten Lasers vom Mittelpunkt M aus nur im Anfang in der Verfahrrichtung V bewegt; danach steuert man ihn zweckmäßigerweise so, daß er in Form eines Bogens B (Figur 2) an die gewünschte Kreisbahn K angenähert wird.

Wie erwähnt, hängt der Winkel der Sprungrichtung S zum Mittelpunkt M hin vom jeweiligen Ausgangspunkt A ab, der in der Regel eine vorangehende Lochbohrung ist. Je nach Anordnung und Reihenfolge der zu bearbeitenden Löcher kann somit die Sprungrichtung S jeden Winkel einnehmen. Da der Winkel der Verfahrrichtung V aber fest vorprogrammiert ist, kommt es im Mittelpunkt M zu einer mehr oder wenigen großen Winkeländerung. Der ideale Fall ist in Figur 2 gezeigt. Dabei liegt der Ausgangspunkt A so, daß die Sprungrichtung S annähernd die gleiche ist wie die Verfahrrichtung V, die mit 0° in der X-Achse angenommen ist. Die Achse des Laserstrahls kann also über den Mittelpunkt M hinweg ohne Unterbrechung weiter bewegt werden, so daß die Ablenkeinheit eine kontinuierliche Bewegung ausführen kann. Der Laserstrahl wird also in der Verfahrrichtung V auf die Kreisbahn zu bewegt, wobei er dann entsprechend dem gestrichelt dargestellten Bogen B oder alternativ auf der Verfahrrichtung V in die Kreisbahn K gebracht wird und entlang der gestrichelt dargestellten Kreisbahn K den Bohrvorgang durchführt.

Der ungünstigste Fall für die Führung des Laserstrahls ist in Figur 3 gezeigt. In diesem Fall kommt die Achse des Laserstrahls in einer Sprungrichtung an, die der vorgegebenen Verfahrrichtung V um 180° entgegengesetzt ist. Die Strahlachse muß also im Mittelpunkt M eine Richtungsumkehr um 180° vollführen. Dazu muß die Ablenkeinheit zunächst gestoppt und in neuer Richtung beschleunigt werden.

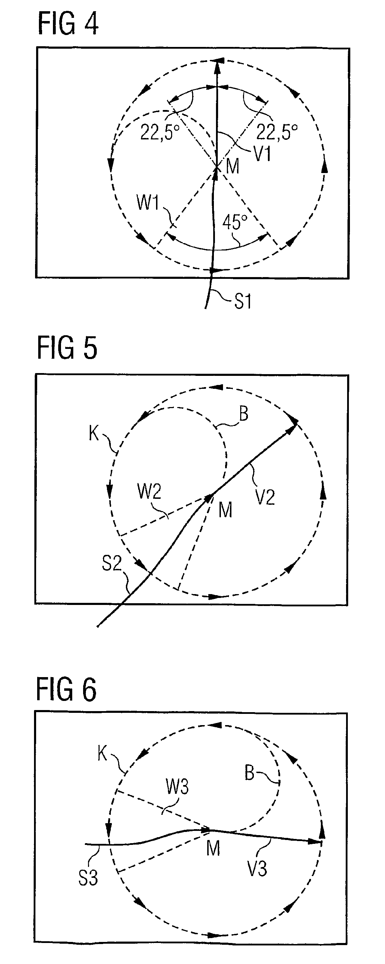

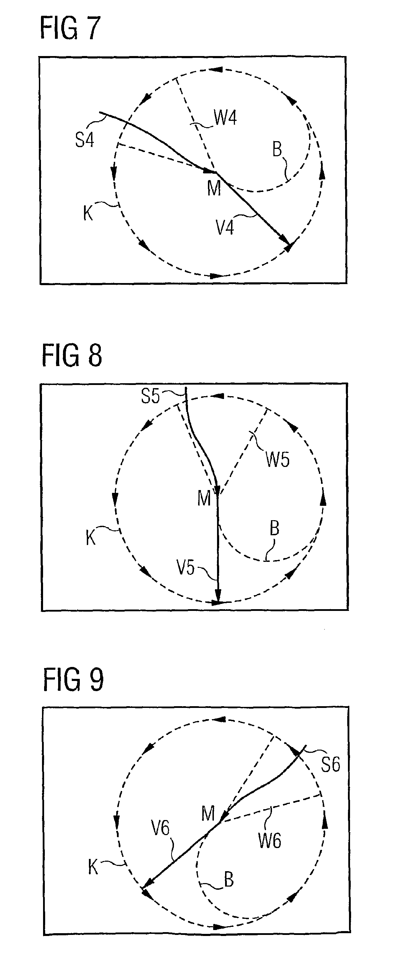

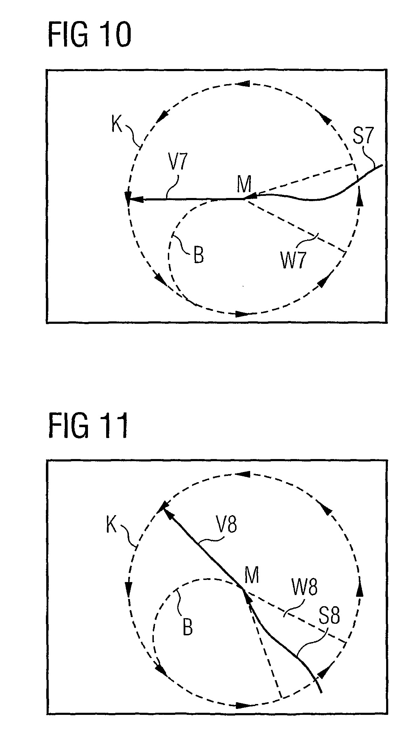

Um solche Verzögerungen durch starke Richtungsänderungen im Mittelpunkt des zu bohrenden Loches zu vermeiden, wird erfindungsgemäß die Verfahrrichtung im Winkel möglichst an die Sprungrichtung S angepaßt. Da eine jeweilige Anpassung des Bohrprogramms, um den Idealfall (gemäß Fig. 2) für jede Richtung zu erreichen, sehr aufwendig ist, wird eine bestimmte Anzahl von Bohrprogrammen fest vorgegeben, und je nach der Sprungrichtung wird jeweils das Programm mit der geringsten Abweichung zwischen Sprungrichtung und Verfahrrichtung ausgewählt. Im hier beschriebenen Beispiel sind acht Programme mit jeweils um 45° versetzten Verfahrrichtungen V1 bis V8 vorgegeben, wobei jeder Verfahrrichtung ein Winkelbereich für eine ankommende Sprungrichtung zugeordnet ist. Diese acht vorgegebenen Kombinationen von Sprungrichtung und Verfahrrichtung sind in den Figuren 4 bis 11 gezeigt. Die acht vorprogrammierten Verfahrrichtungen V1 bis V8 sind jeweils mit einem Winkelbereich W1 bis W8 gekoppelt, so daß je nach dem, in welchem Winkelbereich W1 bis W8 eine Sprungrichtung S1 bis S8 fällt, automatisch das zugehörige Bohrprogramm mit der Verfahrrichtung S1 bis S8 ausgelöst wird. Dadurch ergibt sich zwischen Sprungrichtung und Verfahrrichtung eine maximale Winkeländerung im Mittelpunkt von 22,5°. Die Richtung aus dem Lochmittelpunkt ist gegeben durch die Winkelhalbierende des jeweils gegenüberliegenden Einfallswinkelbereichs. Wenn dieser Winkelbereich 45° beträgt, ist die Winkeländerung pro Bereich maximal 22,5° (siehe Figur 4).

Da in der Regel die Positionen und die Reihenfolge der Abarbeitung für die zu bohrenden Löcher auf dem Substrat bzw. der Leiterplatte bekannt sind, kann bereits vorab für jedes zu bohrende Loch das zutreffende Bohrprogramm festgelegt werden, so daß keine Zeitverluste durch eventuell nicht ausreichende Prozessorleistung entstehen können. Im übrigen ist die Anzahl der festgelegten Verfahrrichtungen keineswegs auf das beschriebene Beispiel beschränkt, sondern es kann je nach Erfordernis jede andere Anzahl von vorgegebenen Verfahrrichtungen und zugehörigen Bohrprogrammen vorgesehen werden oder im Idealfall online die Richtung berücksichtigt werden.

## Patentansprüche

1. Verfahren zum Bohren von Löchern mittels eines Laserstrahls in einem Substrat, insbesondere in einem elektrischen Schaltungssubstrat (1), wobei der Laserstrahl mit einem Strahlfleckdurchmesser (F1), der kleiner ist als der zu bohrende Lochdurchmesser, auf mindestens einer Kreisbahn (K) bewegt wird,
**dadurch gekennzeichnet,**
**daß** jeweils bei der Ausrichtung des Laserstrahls (4) auf ein neues Bohrloch (14,15) die Strahlachse zunächst in einer durch ihre Startposition (A) vorgegebenen Sprungrichtung (S) in den Mittelpunkt (M) des zu bohrenden Loches und dann in einer definierten radialen Verfahrbewegung (V) aus dem Mittelpunkt heraus auf eine definierte Kreisbahn (K) gelenkt wird, und
**daß** die Winkelrichtung der Verfahrbewegung (V) in Abhängigkeit von der Sprungrichtung (S) derart definiert wird, daß eine Richtungsänderung der Strahlachse im Mittelpunkt (M) einen vorgegebenen maximalen Winkel nicht übersteigt oder die Richtung beibehalten wird.

2. Verfahren nach Anspruch 1,
**dadurch gekennzeichnet,**
**daß** entsprechend dem vorgegebenen maximalen Winkelbereich eine Anzahl von festen Winkelrichtungen (V1 bis V8) für die Verfahrbewegung vorgegeben ist und daß in Abhängigkeit von der Sprungrichtung (S1 bis S8) eine dieser Winkelrichtungen (V1 bis V8) ausgewählt wird.

3. Verfahren nach Anspruch 2,
**dadurch gekennzeichnet, daß** jeder Winkelrichtung (V1 bis V8) für die Verfahrbewegung ein Kreissektor für Sprungrichtungen (S1 bis S8) zugeordnet ist, wobei die maximale Winkeländerung 360°/2n beträgt, wenn n die Anzahl der Sektoren ist.

4. Verfahren nach Anspruch 3,
**dadurch gekennzeichnet,**
**daß** acht Winkelbereiche (W1 bis W8) mit je 45° vorgegeben sind und diesen entsprechend acht Winkelrichtungen (V1 bis V8) für die Verfahrbewegung mit einem entsprechenden Bohrprogramm vorgegeben sind.

5. Verfahren nach Anspruch 3 oder 4
**dadurch gekennzeichnet,**
**daß** Anzahl und Reihenfolge von zu bohrenden Löchern auf einem Substrat vorprogrammiert werden und daß entsprechend den dabei auftretenden Sprungrichtungen für jedes Bohrloch ein Bohrprogramm mit entsprechender Verfahrrichtung (V1 bis V8) fest vorgegeben ist.

## Claims

1. A method for drill holes by means of a laser beam in a substrate, in particular in an electric circuit substrate (1), wherein the laser beam having a beam spot diameter (F1) smaller than the diameter of the hole to be drilled is moved on at least one circular path (K),
**characterized in that**
each time the laser beam (4) is oriented to a new drill hole (14, 15), the beam axis is first directed in a jump direction (S) predetermined by its starting position (A) to the center point (M) of the hole to be drilled and then out of the center point to a defined circular path (K) in a defined radial traversing movement (V), and
that the angle direction of the traversing movement (V) is defined depending on the jump direction (S) such that a change of direction of the beam axis in the center point (M) does not exceed a predetermined maximum angle or the direction is maintained.

2. The method according to claim 1, **characterized in that** according to the predetermined maximum angle range a number of fixed angle directions (V1 to V8) is predetermined for the traversing movement and that depending on the jump direction (S 1 to S8) one of these angle directions (V1 to V8) is selected.

3. The method according to claim 2, **characterized in that** a circle sector for jump directions (S 1 to S8) is assigned to each angle direction (V1 to V8) for the traversing movement, with the maximum change of angle being 360°/2n if n is the number of sectors.

4. The method according to claim 3, **characterized in that** eight angle ranges (W1 to W8) each enclosing 45° are predetermined and that correspondingly to these, eight angle directions (V1 to V8) are predetermined for the traversing movement using a corresponding drilling program.

5. The method according to claim 3 or 4, **characterized in that** the number and sequence of holes to be drilled on a substrate are preprogrammed and that according to the jump directions occurring therein a drilling program having a corresponding traversing direction (V1 to V8) is fixedly predetermined for each drill hole.

## Revendications

1. Procédé de perçage de trous dans un substrat au moyen d'un rayon laser, notamment dans un substrat de circuits électriques (1), le rayon laser étant en l'occurrence déplacé, avec un diamètre de spot de rayonnement (F1) qui est plus petit que le diamètre du perçage à effectuer, suivant au moins une trajectoire circulaire (K),
**caractérisé en ce que**,
lors du centrage du rayon laser (4) sur un nouveau trou à percer (14, 15), l'axe du rayonnement est tout d'abord dirigé, selon une direction de déplacement rapide (S) préalablement imposée par sa position de départ (A), sur le centre (M) du trou à percer et ensuite ramené, par un mouvement de déplacement radial défini (V), de cette position au centre suivant une trajectoire circulaire définie (K) et
**en ce que** l'orientation angulaire du mouvement de déplacement (V) est définie en fonction de la direction de déplacement rapide (S) de telle façon qu'un changement de direction de l'axe du rayonnement au niveau du centre (M) n'excède pas un angle maximum préalablement imposé ou que la direction est conservée.

2. Procédé selon la revendication 1
**caractérisé en ce qu'**
en correspondance avec la zone angulaire maximale spécifiée, un certain nombre de directions angulaires fixes (V1 à V8) sont imposées pour le mouvement de déplacement et **en ce qu'**en fonction de la direction de déplacement rapide (S1 à S8) une de ces directions angulaires (V1 à V8) est sélectionnée.

3. Procédé selon la revendication 2
**caractérisé en ce qu'**
à chaque direction angulaire (V1 à V8) d'exécution du mouvement de déplacement est associé un secteur pour les directions de déplacement rapide (S 1 à S8), la modification angulaire maximale étant en l'occurrence de l'ordre de 360°/2n, si l'on désigne par n le nombre des secteurs.

4. Procédé selon la revendication 3
**caractérisé en ce que**
huit zones angulaires (W1 à W8) d'une valeur unitaire de 45° sont spécifiées et qu'en correspondance avec celles-ci huit directions angulaires (V1 à V8) sont imposées pour le mouvement de déplacement, avec un programme de perçage élaboré en correspondance.

5. Procédé selon la revendication 3 ou 4
**caractérisé en ce que**
le nombre et l'ordre successif des trous à percer sur un substrat sont préalablement programmés et **en ce qu'**en fonction des directions de déplacement rapide sélectionnées en correspondance, un programme de perçage, avec une direction de déplacement correspondante (V1 à V8), est imposé pour chaque trou à percer.
